# EUROPEAN PATENT SPECIFICATION

(11) **EP 1 729 943 B1**
(45) Date of publication and mention of the grant of the patent: **19.09.2007**
(21) Application number: 04724604.6
(22) Date of filing: 31.03.2004
(51) Int. Cl.: B29B 15/00

(54) **PROCESS FOR PRODUCING A METAL WIRE COATED BY MEANS OF A PLASMA DEPOSITION TECHNIQUE**
VERFAHREN ZUR HERSTELLUNG EINES MITTELS EINER PLASMAABSCHEIDUNGSTECHNIK ÜBERZOGENEN METALLDRAHTS
PROCEDE DE PRODUCTION D'UN FIL METALLIQUE REVETU AU MOYEN UNE TECHNIQUE DE DEPOT EN PHASE VAPEUR ACTIVE PAR PLASMA

(43) Date of publication of application: 13.12.2006
(73) Proprietor: PIRELLI TYRE S.p.A., 20126 Milano (IT)
(72) Inventor: PAVAN, Federico, Pirelli Tyre S.p.A., I-20126 Milano (IT); AGRESTI, Simone, I-20126 Milano (IT)
(74) Representative: Bottero, Claudio
(86) International application number: PCT/EP2004/003621
(87) International publication number: WO 2005/095078

(56) References cited:
- EP-A- 1 295 985
- WO-A-99/43860
- US-A1- 2004 026 234

## Description

### Field of the invention

The present invention relates to a process for producing a coated steel wire suitable for reinforcing elastomeric materials to be used, for example, in manufacturing tires; tubes, conveyor belts, transmission belts and cables.

In particular, the present invention refers to a process for manufacturing a coated steel wire comprising a steel core and a metal coating layer in a radially outer position with respect to said steel core.

### Prior art

Generally, tire manufacturing processes make use of coated steel wires or cords (comprising a plurality of wires stranded together) which are embedded in an elastomeric material to form, for example, a belt layer or a carcass layer of a tire.

The steel core is typically provided with a metal coating layer to carry out the dual function of providing a suitable corrosion resistance to the wire and of ensuring a good adhesion thereof to the vulcanized elastomeric material.

For example, documents EP-A-0 669 409, EP-A-0 694 631 and EP-A-0 949 356 - in the name of the Applicant - disclose processes for producing a coated steel wire comprising the step of electrochemically depositing a metal coating on the steel core, said metal coating consisting of an alloy of at least two metal components.

In case a brassed coating is provided onto a steel core by means of electrochemical deposition, the process essentially involves the following steps:
- an electrodeposition step in two distinct electrolytic baths, in which a copper plating and a zinc plating of the steel core are successively carried out;
- a thermal treatment step to allow zinc diffusion into copper to form the brass alloy;
- a pickling step in acid solution, typically phosphoric acid, for removing the zinc oxides which have been formed on the surface of the coating layer due to the thermal treatment step; and
- a drawing step for obtaining the desired final diameter of the brassed wire.

Such conventional processes, which comprise the steps of electrochemically depositing at least two metal layers which are transformed into the desired metal alloy by means of a thermal treatment, have a plurality of drawbacks such as, for example, an excessive number of steps to be carried out, a possible decrease of the mechanical resistance of the coated wire due to the thermal treatment step, possible dishomogeneities in the alloy composition, i.e. presence in the coating layer of undesired gradients of concentration of the alloy components in the radial direction and/or in the axial direction of the wire.

Since the deposited metal layers are remarkably thick (e.g. about 0.5 - 1.0 µm), the complete diffusion of the first metal component into the second metal component so as to obtain the metal alloy (e.g. the diffusion of zinc into copper to obtain brass) is ensured by the thermal treatment step wherein the temperature is suitably selected so as to cause the diffusion step to occur (e.g. a temperature in the range of about 450 to 500°C is typically provided).

Document EP-A-1 004 689 - in the name of the Applicant - discloses a process for producing a brass coated steel wire, the process comprising the step of depositing on the steel core at least three alternate unalloyed layers each being of copper or zinc, the outermost of said unalloyed layers being copper, and the step of drawing the coated wire to allow zinc to diffuse into copper so as to form the desired brass coating.

According to document EP-A-1 004 689, the deposition process comprises the step of electrochemically depositing a plurality of metal layers onto the steel core and does not comprise any thermal treatment step since the diffusion step is caused by the heat amount which is produced during the wire drawing step.

The Applicant has noted that the electrochemical deposition processes have the drawback that the thickness of the deposited metal layers can not be reduced below a certain limit which is inherent to the used technology. Generally, metal layers having a thickness lower than 100 nm cannot be deposited by means of an electrochemical deposition technique.

Furthermore, the Applicant has noted that in the coating layer produced according to the electrochemical deposition processes the zinc may not completely diffuse into the copper and, as a result, a dishomogeneous brassed layer may form.

Because of an incomplete diffusion of zinc into copper, the formation of non-diffused copper and β brass with a body-centered cubic structure may occur in the obtained coating layer.

This non uniform composition of the obtained coating layer may give rise to wire corrosion due to the different corrosion potentials of the distinct phases which are present in the coating layer, i.e. non-diffused copper, β brass and α brass.

Furthermore, the non uniform composition of the coating layer may give rise to a decreased adhesion of the coated wire with the elastomeric material in which said coated wire is generally embedded as a reinforcing element, for example in the manufacturing of tires, tubes, conveyor belts, transmission belts and cables. The decreased adhesion between the coated wire and the elastomeric material is essentially due to the presence of the non-diffused copper which is very reactive and gives rise, during vulcanization of the elastomeric material embedding the coated wire, to the formation of a thick layer of copper and zinc sulfides. Since the obtained thick layer of sulfides is very brittle, it breaks and the breaking thereof inevitably causes a loss of adhesion between the coated wire and the elastomeric material.

Moreover, the formation of β brass during the drawing step makes the latter extremely difficult and results in a remarkable and premature wear of the drawing dies.

Furthermore, the thermal treatment step of the known electrochemical deposition processes causes a reduction in the tensile strength of the coated steel wire, which is even up to 5% of the original tensile strength of the material. This tensile strength reduction impairs the effectiveness of the steel wire when used as reinforcing element, particularly in motor vehicle tires.

### Summary of the invention

In the absence of a heat treatment step, the Applicant has perceived that a complete and satisfactory diffusion of a first metal component into a second metal component - so as to form the alloy thereof - can successfully occur during the drawing step if very thin metal layers are deposited onto the steel core.

In particular, the Applicant has perceived that the deposition step of a wire manufacturing process has to be carried out so that the initial coating layer deposited onto the steel core is obtained by depositing a plurality of metal layers, each layer having a thickness lower than about 50 nm.

Preferably, each layer has a thickness comprised between 0.5 nm and 20 nm. More preferably, each layer has a thickness comprised between 1.0 nm and 10 nm.

In a process for continuously producing a-coated steel wire comprising a metal coating layer comprising an alloy made of at least two metal components, the Applicant has found that, in order to achieve a complete diffusion of one metal component into a further at least one metal component to form the alloy, the coating layer has to be obtained by separately depositing a plurality of layers of said at least two metal components so that each layer has a thickness not higher than 50 nm, said alloy being formed during the drawing step of the coated steel wire.

According to an embodiment of the present invention, the step of coating is carried out by alternately depositing onto the steel core separate layers of the at least two metal components so that, at the end of the coating step, the steel core is provided with alternate separate layers, each layer being formed by one of said at least two metal components.

According to a further embodiment, if the metal coating layer comprises an alloy of at least three metal components, the process of the present invention comprises the step of depositing onto the steel core layers of an alloy of at least two metal components of said at least three metal components. For example, in the case a metal coating layer made of a ternary alloy has to be deposited, the process of the present invention comprises the step of depositing layers of an alloy of the first and second metal components, and layers of the third metal component. Preferably, the layers of the alloy of the first and second metal components are alternately deposited with respect to the layers of the third metal component.

Preferably, the Applicant has found that the above metal layers are obtained by means of a plasma deposition technique.

A plasma deposition technique allows to obtain a coated wire the coating layer of which is uniform and homogeneous both in the radial and in the axial directions in each deposited layer. Such a technique, in fact, succeeds in minimizing the variations of the amount of metal deposited in the axial direction and in the radial direction of the wire as well as in reducing the formation of concentration gradients of each component of the alloy in both of said directions. The characteristics of uniformity and homogeneity of the coating layer are particularly important for the purposes of conferring to the steel wire the desired corrosion resistance and, furthermore, uniform and homogeneous metal layers allow better diffusion of one metal into the other for the obtainment of the alloy.

Furthermore, a deposition step based on a plasma technique advantageously allows to form a finished coating layer more efficiently with respect to electrochemical deposition processes, also because the process of the present invention does not require either a thermal treatment step after the deposition of the metal coating layers, or a pickling step in phosphoric acid.

Moreover, the absence of such a thermal treatment step - which is typically carried out at temperatures of about 450°C to 500°C - does not cause any reduction in the tensile strength of the coated steel wire.

Furthermore, the amount of impurities, such as for example oxides, present in the coating layer is drastically reduced with respect to the amount present in the wires produced by electrochemical deposition process.

Moreover, since a plasma deposition technique allows to obtain very thin metal layers, the initial coating layer of the steel wire - which is selected on the basis of the desired final thickness of the coating layer provided to the finished steel wire - can be formed by a plurality of very thin layers. This aspect is particularly relevant in terms of process productivity and product quality since the high number of very thin, uniform and homogeneous metal layers increases the ductility of the initial coating layer so that the drawability thereof is remarkably improved and, as a consequence, the wear of the drawing dies is remarkably reduced.

In the following description and in the claims, the expressions "initial diameter of the core" and "initial thickness of the coating layer" are used to indicate the diameter of the steel core and, respectively, the thickness of the coating layer before the drawing step is carried out.

In the following description and in the subsequent claims, the expressions "final diameter of the core" and "final thickness of the coating layer" are used to indicate the diameter of the steel core and, respectively, the thickness of the coating layer after the drawing step is carried out.

In a process for continuously manufacturing a coated wire, the Applicant has noticed that, once the line speed is selected in view of the desired plant productivity, and the wire diameter as well as the coating layer thickness before the drawing step are selected to obtain a desired final wire diameter and a final coating layer thickness in the finished coated wire, the temperature of the wire while passing through the drawing die and the pressure conditions inside the drawing die are substantially constant during the wire manufacturing process.

In particular, the Applicant has noted that the values of said parameters (i.e. temperature and pressure) essentially depend on the die geometry (and thus on the friction occurring between wire and dies), on the thermorefrigerant properties of the lubricant which is used in the drawing dies and, as mentioned above, on the set up of the line speed as well as on the final steel core diameter and on the final coating layer thickness.

The Applicant has thus perceived that, at a given temperature of the coated wire in the drawing step, the complete diffusion of a metal component into a further metal component to form an alloy thereof can occur if the deposited metal layers have very limited thicknesses so that the diffusion time of one component into a further one is substantially comparable with the residence time of the wire inside of the drawing die, said residence time generally having an order of magnitude of about 10⁻³ s.

The Applicant has perceived that the diffusion time can be compared with the residence time inside of the drawing die since, at the exit of the drawing die, the coated wire undergoes a very quick cooling step which stops the diffusion of one component into a further one.

Furthermore, the Applicant has noted that by decreasing the thickness of the deposited metal layer of one order of magnitude (e.g. from 100 nm to 10 nm), the diffusion time, which is necessary to obtain a complete diffusion of a metal component into a further metal component, decreases of about two orders of magnitude (e.g. from 0.1 s to 1.0 ms at a temperature of about 420°C)..

Preferably, the deposition of the plurality of metal layers forming the initial metal coating layer is obtained by means of a magnetron sputtering technique.

In the following description and in the subsequent claims, the expression "plasma deposition technique" is used to indicate any deposition technique which uses plasma: a) as means for activating the vaporization of the metal to be deposited (such as for example in sputtering and in evaporation by voltaic arc); b) or as carrier for the metal to be deposited (such as for example in plasma spray); c) or as means for dissociating the process gases (such as for example in plasma enhanced chemical vapor deposition (PECVD)) in a vacuum deposition chamber.

Preferably, the process of the present invention comprises the step of submitting the steel core to at least one surface treatment so as to predispose the core surface to receive the coating layer.

The surface treatment is aimed to improve the wire quality by eliminating, or at least reducing, any macrorugosity or unevenness which can be present on the core surface. Preferably, said surface treatment step comprises the step of electrolytically pickling the core into a bath containing for example sulfuric acid, and by subsequently washing the pickled core in water. Subsequently, in order to eliminate any residual water from the washed core, the latter is dried, for example by means of hot air, e.g. at about 80°C, which is preferably produced by a blower arranged downstream of the washing step.

Preferably, the process of the present invention further comprises the step of thermally treating the steel core so as to cause annealing of steel. This treatment preferably consists in a patenting thermal treatment which may be carried out in a furnace. The patenting step (which essentially comprises heating the wire at about 900 - 1050°C for a time of about 20 - 40 s and successively cooling it to about 520 - 580°C for a time of about 5 - 20 s) is aimed to provide the steel core with a pearlitic structure which has a very high work-hardening coefficient and thus can be easily drawn.

In accordance with a preferred embodiment of the process of the invention, the steel core is conveyed through a sequence of steps: surface treatment, thermal treatment, deposition and drawing steps respectively, at a speed preferably comprised in the range from about 10 m/min to about 80 m/min.

Preferably, the above-mentioned surface treatment, thermal treatment, deposition and drawing steps are carried out in a continuous manner.

In the following description, the expression "in a continuous manner" is used to indicate the absence, among the steps of the manufacturing process of the present invention, of any intermediate storage of semi-finished products, so as to continuously produce a coated wire or a coated cord - obtained by stranding a plurality of coated wires - of undefined length in a single production line.

In such a way, it is advantageously possible to obtain a coated steel wire by means of a single manufacturing process which is carried out in a continuous manner from the step of producing the steel core to the step of drawing the coated wire, optionally including additional conventional preliminary treatments effected on the steel core or additional finishing treatments effected on the coated wire (e.g. a phosphating treatment of the core or of the coated wire in order to improve the drawing thereof).

Optionally, the process of the present invention may also include some preliminary steps to obtain a steel core of a predetermined diameter starting from a wire rod.

For example a mechanical removal of the oxides present on the wire rod, known in the field with the term of descaling, may be carried out. The descaling step is carried out to smooth the wire rod, i.e. to substantially eliminate the roughness thereof. In such way, any surface roughness, which may have a remarkable depth in the case of a rod made of steel, typically in the range of from about 1.5 µm to 2.0 µm, is advantageously eliminated, thus improving the adhesion of the coating layer to the core in the successive depositing step and the effectiveness of the deposition step. The descaling step is preferably followed by a dry drawing of the wire rod, at the end of which a steel core having a predetermined initial diameter is obtained.

Subsequently to these preliminary steps, according to the process of the invention, the steel core undergoes a surface treatment which is aimed to remove oxides possibly present on the steel core surface. The surface treatment preferably comprises the steps of pickling, washing and optionally drying the steel core. The pickling step is carried out by introducing the steel core into a pickling bath, such as for example a bath containing sulfuric acid. Successively, the pickled core is washed by means of water and optionally dried, preferably by means of hot air produced by a blower (e.g. at a temperature comprised from about 70°C to about 90°C, more preferably at a temperature of about 80°C).

Alternatively to the pickling step, the core may undergo alternative surface treatments, such as for example etching, cleaning and activation by a plasma etching technique, for example by conveying argon ions onto the core surface.

According to a preferred embodiment, the process of the invention further comprises the step of dry drawing the core before said thermal treatment, preferably in such a manner to obtain a slight reduction of the core diameter, such as for example comprised between about 1 and about 3%.

According to an alternative embodiment of the process of the invention, the above-mentioned surface treatment, such as for example the pickling or any other alternative treatment suitable for the purpose, may be carried out on a wire rod, preferably preliminarily descaled, and the surface treatment is followed by a dry drawing aimed at obtaining a steel core having a predetermined initial diameter.

Successively, according to the process of the invention, a thermal treatment is carried out on the steel core. By way of indication only, the thermal treatment of the steel core preferably comprises the step of gradually heating the core to a predetermined temperature, such as for example comprised between about 900°C and about 1000°C, and the subsequent step of cooling the core to a predetermined temperature, such as for example comprised between about 530°C and about 580°C. Preferably, the cooling step is carried out by introducing the steel core into a molten lead bath. Alternatively, the cooling step is carried out by introducing the steel core into a bath of molten salts (i.e. chlorates, carbonates), by passing the steel core through zirconium oxide powders or by means of air.

The process of the present invention preferably further comprises a further thermal treatment, which is preferably carried at the same working conditions mentioned above and which comprises a further gradual heating step and a subsequent cooling step of the steel core.

When a first and a second thermal treatment are provided, a further dry drawing is preferably carried out after the first thermal treatment. If additional thermal treatments are provided, a dry drawing between each couple of thermal treatments is preferably carried out.

When a single thermal treatment is provided, a further slight dry drawing is preferably carried out by using a drawing die which is preferably connected in an gas-tight manner with the vacuum deposition chamber, at the inlet thereof. More preferably, such slight drawing step may be carried out by means of a so-called split drawing die, which essentially comprises a drawing die having two symmetrical halves. Thanks to this feature, the drawing die may be advantageously substituted in a simple manner, without interrupting the production process.

Subsequently to said optional thermal treatment(s), the process of the present invention further comprises the plasma deposition step mentioned above, which is preferably carried out in at least one vacuum deposition chamber at a first predetermined pressure.

In accordance with a preferred embodiment of the process of the invention, the above-mentioned plasma deposition technique is selected from the group comprising: sputtering, evaporation by voltaic arc, plasma spray and plasma enhanced chemical vapor deposition (PECVD).

Preferably, the deposition technique used by the process of the invention is the sputtering technique according to which at least one conventional vacuum deposition chamber is provided. Said chamber comprises a vacuum pump (preferably a diffusion pump or a turbomolecular pump) which is suitable for creating a predetermined pressure (e.g. in the range from 0.1 mbar to 5x10⁻³ mbar) inside of it. Furthermore, the vacuum deposition chamber is provided with means for supplying a carrier gas, preferably argon, and with at least a couple of cathodes, each cathode being made of a metal component of the alloy to be deposited onto the steel core.

According to the process of the present invention, the steel core - which constitutes the anode - is made to pass into the vacuum chamber, particularly in the region comprised between the cathodes so that the metal layers can be deposited as described in the following of the present invention with reference to a preferred embodiment of the present invention.

Sputtering essentially consists of a ionic bombardment of the cathodes, typically at an energy equal to about 100 - 1000 eV and a current comprised between about 0.1 and about 10 A, with ions of the carrier gas obtained under the action of an electrical field generated by applying a voltage between the cathodes and the anode. More specifically, ions of the carrier gas are accelerated towards the cathodes, essentially causing a series of collisions with a consequent emission of cathodes atoms directed towards the anode, i.e. towards the steel core, towards which free electrons are also accelerated. The free electrons ionize by collision further atoms of carrier gas, whereby the process repeats itself and self-sustains as far as sufficient energy is supplied.

As mentioned above, preferably the deposition step of the process of the present invention is carried out by means of the magnetron sputtering technique. This technique advantageously increases the deposition rate of the metal layers essentially thanks to the effect exerted on the electrically charged particles by a magnetic field, the latter inducing a confinement action on the electrons in proximity of the cathodes and thus increasing the plasma density.

In the following description, in case the magnetron sputtering technique is considered, the expression "cathode" (or "magnetron") is used to indicate an assembly comprising the coating material (which is the target and is preferably in the form of a plate) and a plurality of magnets which are arranged behind the coating material and which create a magnetic trap for the charged particles - e.g. argon ions - in front of the coating material. Furthermore, since the sputtering process causes the heating of the coating material, generally the cathode further comprises a cooling system, typically a plurality of channels for the passage of cooling water thereinto.

According to the process of the present invention, the steel core is conveyed into said at least one vacuum deposition chamber according to multiple passages so that the deposition steps of the alloy metal components are carried out a plurality of times.

In more details, the steel core is made to pass through a sequence of at least two cathodes, each cathode being made of a distinct metal component to be deposited, so that while passing through said cathodes a plurality of layers of said metal components is deposited onto the steel core.

According to the present invention, the term "metal component" is used to indicate a single metal element or a combination of distinct metal elements.

Preferably, the cathodes are provided in the form of rectangular plates and are longitudinally distributed along the core path inside of the vacuum chamber.

More preferably, two cathodes made of the same metal component to be deposited are disposed on opposite sides with respect to the core moving direction. In more details, a first cathode made of a first metal component is provided above the steel core and a second cathode made of said first metal component is provided below the steel core, said first and second cathodes being parallel to each other and transversally arranged with respect to the core moving direction.

According to a preferred embodiment of the present invention, pairs of cathodes - i.e. a cathode arranged above the core direction and a cathode arranged below the core direction - made of a first metal component are positioned inside the vacuum chamber - along the core deposition path - alternately and separately to pairs of cathodes made of a second metal component so that alternate and separate layers of a first metal component and of a second metal component can be deposited onto the steel core.

In case the coating layer consists of a ternary alloy, pairs of cathodes made of a third metal component are alternately and separately arranged with respect to said first and second cathodes so that alternate and separate layers of first, second and third metal components are deposited onto the steel core.

Preferably, the steel core passes through the vacuum chamber length a predetermined number of times so that the core deposition path is advantageously improved without remarkably increasing neither the vacuum chamber length nor the number of cathodes which are necessary for ensuring that a predetermined coating layer thickness is provided to the steel core, while maintaining a high conveying speed thereof, e.g. in the order of 80 m/min.

For example, such a deposition path can be obtained by conveying the steel core according to a forward and backward length to be covered for a predetermined number of times so as to increase the residence time of the core in the deposition zone until a desired initial thickness of the coating layer is achieved. For example, said forward and backward length can be obtained by providing the vacuum chamber with means for feeding back the core, e.g. by means of pulleys, so that at least one bundle of steel cores is formed inside the vacuum deposition chamber.

Furthermore, according to a preferred embodiment of the process, the deposition step is carried out simultaneously on a plurality of steel cores which are conveyed along a predetermined conveying direction, so as to advantageously increase the productivity of the process.

Alternatively to the rectangular form, the cathodes may be provided in the form of circular plates through which the anode - i.e. the steel core - is made to pass.

Alternatively, the cathodes are provided in the form of tubes the steel core is made to pass through.

Alternatively to the sputtering technique, a deposition by voltaic arc technique may be used, the latter consisting of an ionic or electronic bombardment, typically at an energy in the order of 100 eV, of the metals to be deposited.

The plasma deposition technique may also consist of the so-called plasma spray, essentially consisting of feeding a plasma flow of fine powders of the metals to be deposited, preferably having a size of about 0.1 µm. The powders, accelerated and heated by the plasma until the melting points of the metals are reached, are directed onto the steel core to be coated, thus creating a coating consisting of a plurality of overlaying layers of metal particles.

The plasma deposition technique by means of which the above-mentioned deposition step of the process of the invention is carried out may also be the plasma enhanced chemical vapor deposition (PECVD). Such a technique essentially consists of the plasma dissociation of precursor gases in a vacuum chamber (for example at a pressure equal to about 0.1-10 Torr). Preferably, the precursor gases comprise metallorganic compounds, such as for example (hexafluoroacetylacetonate)copper(trimethylvinylsilane) ((hfac)Cu(VTMS)), (hexafluoropentadionate)copper(vinyltrimethoxysilane) ((hfac)Cu(VTMOS)), diethylzinc and diphenylzinc, which advantageously have low decomposition temperatures, in the order of 25-80°C.

According to a further preferred embodiment of the present invention, the process comprises the steps of providing a first vacuum deposition chamber and a second vacuum deposition chamber which are arranged in series.

According to said embodiment, during the manufacturing of the coated wire only one of said vacuum chambers carries out the deposition step of the metal layers while the other chamber is put in stand-by mode. In such a way, it is not necessary to interrupt the production process to substitute the source of the metals to be deposited onto the core, e.g. the metal cathodes in a sputtering process. In fact, by providing two distinct vacuum chambers, the substitution of the metal sources, which is necessary when the sources are completely consumed or when different metals have to be deposited, may be advantageously made in one chamber while the other one is switched to an operative mode, thus avoiding production stops and resulting in an increase of the productivity of the process of the invention.

Preferably, the steel wire is coated in at least one vacuum deposition chamber subjected to a first predetermined pressure, which is preferably comprised between about 10⁻³ mbar and about 10⁻¹ mbar when the plasma deposition technique is sputtering, more preferably in the order of 10⁻² mbar.

Preferably, the process of the invention further comprises the step of conveying the steel core in at least one pre-chamber subjected to a second predetermined pressure higher than said first predetermined pressure, said at least one pre-chamber being arranged upstream of said at least one vacuum chamber.

In such way, the desired vacuum condition is advantageously achieved in at least two subsequent steps, i.e. in a stepwise manner, which is simpler and more convenient from an economical point of view with respect to the achievement of a vacuum condition in a single step.

Furthermore, the provision of at least one pre-chamber advantageously allows to preserve the vacuum deposition chamber (in which the depositing step is carried out) from the contamination of dusts and external agents in general, such as oxygen, which are detrimental to the effectiveness of the depositing step and to the purity of the coating layer to be deposited. Such advantageous effect can simply be achieved by introducing in the at least one pre-chamber a flow of a chemically inert gas.

Preferably, the at least one pre-chamber contains the same gas used as carrier gas in the vacuum deposition chamber, thus allowing to use a supply of gas of the same type both for the pre-chamber and for the vacuum deposition chamber.

More preferably, the above-mentioned chemically inert gas is argon, which is very convenient from an economical point of view, thus resulting in a reduction of the production costs.

Preferably, a further pre-chamber subjected to the above-mentioned second predetermined pressure is provided downstream of the at least one vacuum deposition chamber.

Preferably, said second predetermined pressure is comprised between about 0.2 mbar and about 10 mbar, more preferably in the order of about 1 mbar.

According to a further preferred embodiment, the process of the invention comprises the step of providing a first deposition chamber and a second vacuum deposition chamber arranged in series as described above, the first vacuum deposition chamber being arranged downstream of a first pre-chamber as described above and the second vacuum deposition chamber being arranged downstream of a second pre-chamber separating the two vacuum deposition chambers, a third pre-chamber being arranged downstream of the second vacuum deposition chamber.

Preferably, the alloy forming the coating layer is different from the steel forming the core.

Preferably, the metal coating layer which is deposited onto the steel core is a binary metal alloy. Alternatively, the metal coating layer is a ternary alloy.

Preferably, the metals of the coating layer are selected from the group comprising: copper, zinc, manganese, cobalt, tin, molybdenum, iron, nickel, aluminum and alloys thereof.

More preferably, the coating layer is made of brass, the latter being particular advantageous since it provides the steel wire with high corrosion resistance. According to said preferred embodiment, the coating layer made of brass has a copper content of from about 60% to about 72% by weight, more preferably of from about 64% to about 67% by weight.

If copper is present in a percentage lower than 60% by weight, there is the undesired formation of β brass while, if copper is present in a percentage greater than 72% by weight, the wire is excessively reactive with the elastomeric material which the wire is intended to reinforce. Such a reactivity of the wire with the elastomeric material causes the formation on the wire of a thick layer of sulfides which causes an undesired worsening of the wire properties. As a consequence, in the above-mentioned preferred range of values of copper composition, the formation of β brass is advantageously avoided, while maintaining the reactiveness of the wire with elastomeric materials at an acceptable level.

Alternatively, the coating layer is an alloy selected from the group consisting of: Zn-Co, Zn-Mn, Zn-Fe, Zn-Al, Cu-Mn, Cu-Sn, Cu-Zn-Mn, Cu-Zn-Co, Cu-Zn-Sn, Zn-Co-Mo, Zn-Fe-Mo, Zn-Ni-Mo.

The preferred composition of the Zn-Co alloy is 99% Zn, 1% Co; the preferred composition of the Zn-Mn alloy is 98% Zn, 2% Mn; the preferred composition of the Zn-Fe alloy is 95% Zn, 5% Fe; the preferred composition of the Zn-Al alloy is 95% Zn, 5% Al; the preferred composition of the Cu-Mn alloy is 80% Cu, 20% Mn; the preferred composition of the Cu-Sn alloy is 95% Cu, 5% Sn; the preferred composition of the Cu-Zn-Mn alloy is 63% Cu, 34% Zn, 3% Mn; the preferred composition of the Cu-Zn-Co alloy is 63% Cu, 34% Zn, 3% Co; the preferred composition of the Cu-Zn-Sn alloy is 67% Cu, 30% Zn, 3% Sn; the preferred composition of the Zn-Co-Mo alloy is 99% Zn, 0.5% Co, 0.5% Mo; the preferred composition of the Zn-Fe-Mo alloy is 99% Zn, 0.5% Fe, 0.5% Mo; the preferred composition of the Zn-Ni-Mo alloy is 99% Zn, 0.5% Ni, 0.5% Mo.

Preferably, the deposited coating layer has an initial total thickness in the range from about 0.5 µm and about 2.0 µm. More preferably said total thickness is of about 1.5 µm.

Preferably, the drawing step is carried out in an emulsion bath which comprises a predetermined amount of a lubricating agent, for example a lubricating oil conventional *per se,* so that the drawability of the wire is advantageously improved.

Such embodiment is particularly preferred when the coating layer comprises a material having poor drawability, such as for example a Zn-Mn alloy.

More preferably, the lubricating agent is selected from the group comprising: phosphorous containing compounds (e.g. organic phosphates), sulfur containing compounds (e.g. thiols, thioesters, thioethers), chlorine containing compounds (e.g. organic chlorides). Preferably, said lubricants are the so-called "Extreme Pressure Lubricants", i.e. lubricants which decompose at high temperature and pressure (e.g. giving rise to the formation of phosphides, sulfides and chlorides of iron, copper or zinc).

Preferably, the step of drawing the coated wire is carried out by means of drawing dies made of tungsten carbide or of diamond, which are conventional per se.

Still more preferably, the coating material comprises a predetermined amount of phosphorous. Advantageously, the drawability of a steel wire having a coating layer which comprises a predetermined amount of phosphorous is improved without affecting the adhesion of the coating layer to the elastomeric material in which the coated wire is intended to be embedded. This effect may be accomplished, for instance, by including a predetermined amount of phosphorous in at least one of the cathodes.

Preferably, the coating material comprises phosphorous in an amount of about 1-3% by weight, more preferably in an amount of about 2% by weight, with respect to the total weight of the coating metal.

Advantageously, by including phosphorous in such preferred amount in the metal components to be deposited onto the steel core, e.g. by making the cathodes to contain phosphorous, the plasma deposition step involved in the process of the invention allows to deposit metal layers comprising phosphorous exactly in the same amount (i.e. 1-3%) in an uniform manner. Therefore, since phosphorous is uniformly present in the whole thickness of the coating layer, the subsequent drawing step is improved thanks to the lubricating action of the phosphorous, independently of the drawing degree which has been set.

Furthermore, thanks to the fact that the coating layer is deposited by means of a plasma deposition technique, the percentage variation of the amount of said lubricating agent in said coating layer is lower than about 1% by weight, more preferably comprised between about 0.01% and about 1% by weight, in the radial direction of the wire with respect to the weight of the metal forming the coating layer.

In an analogous manner, the percentage variation of the amount of said lubricating agent in said coating layer is lower than about 1% by weight, more preferably comprised between about 0.01% and about 1% by weight, in the axial direction of the wire with respect to the-weight of the metal forming the coating layer.

Preferably, the drawing step is carried out in such a way as to obtain a steel core having a final diameter which is reduced of about 75-95% with respect to the initial diameter thereof, more preferably of about 80-90% and, still more preferably, of about 85% with respect to the initial diameter.

In accordance with a preferred embodiment of the process of the invention, the drawing step is carried out in such a way as to obtain a coating layer having a final thickness which is reduced by about 75-95% with respect to the initial thickness thereof, more preferably by about 78-88% and, still more preferably, by about 83% of the initial thickness.

Preferably, the initial diameter of the steel core is comprised between about 0.85 mm and about 3.00 mm and the drawing step is carried out in such a way as to obtain a steel core having a final diameter comprised in the range 0.10-0.50 mm.

As mentioned above, the initial thickness of the coating layer is comprised between about 0.5 and about 2 µm and the drawing step is carried out in such a way as to obtain a metal coating layer having a final thickness comprised in the range from 80 to 350 nm.

Preferably, the deposition step of the process of the present invention is carried out so that each deposited metal layer has an initial thickness in the range from about 0.50 nm and 50 nm, more preferably from about 1.0 nm and 10 nm.

In the case a brass coating has to be obtained, preferably the thickness of the copper layers is comprised between 1.5 nm and 10 nm, while the thickness of the zinc layers is comprised between 0.8 nm and 5 nm.

The process of the present invention may further comprise the step of stranding a plurality of coated wires - which have been obtained as described above - to produce a steel cord which can be advantageously employed in reinforcing elastomeric materials, such as for example a tire belt layer.

### Brief description of the drawing

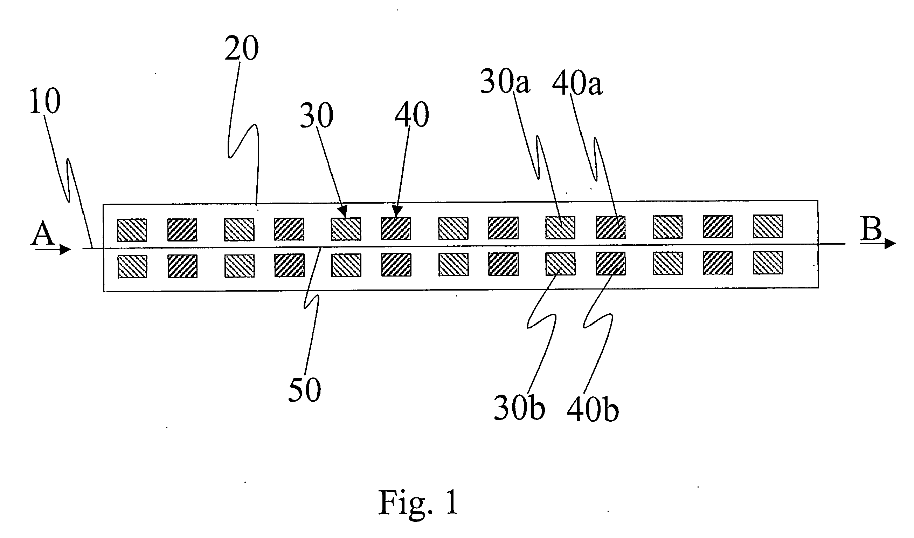

Additional features and advantages of the invention will become more readily apparent from the description of some preferred embodiments of the process with reference to the attached drawing in which, for illustrative and not limiting purposes, fig. 1 is a schematic, side view of the deposition step of the process of the present invention, said deposition step being carried out by means of the magnetron sputtering technique.

### Detailed description of the preferred embodiments

According to the preferred embodiment shown in Figure 1, the steel core 10 enters (arrow A) the vacuum chamber 20 in which the deposition step of a plurality of layers of two different metals is carried out.

As mentioned above, before entering the vacuum chamber 20, the wire 10 undergoes a plurality of treatments (not shown in Figure 1) such as, for instance, surface treatment, patenting treatment, descaling treatment, dry drawing.

According to the embodiment shown in Figure 1, the vacuum chamber 20 is provided with a plurality of first cathodes 30 and second cathodes 40, said first and second cathodes being made of a different metal. For instance, in case the coating layer to be deposited is brass, the first cathodes 30 are made of copper and the second cathodes 40 are made of zinc.

According to said preferred embodiment, the first cathodes 30 are alternated to the second cathodes 40 along the longitudinal development of the vacuum chamber. In more details, a regular and alternate sequence of first and second cathodes 30, 40 is present inside the vacuum chamber so that, while passing through said cathodes, a plurality of metal layers is alternately deposited onto the steel core 10.

The cathodes 30, 40 in Figure 1 are in the form of rectangular plates and are longitudinally distributed along the path 50 of the steel core inside the vacuum chamber.

According to this preferred embodiment, each cathode 30, 40 is formed by two distinct cathodes - 30a, 30b and 40a, 40b, respectively - so that a first cathode 30a is placed above the steel core 10 and a first cathode 30b is placed below the steel core 10. The same applies also to the second cathodes 40 so that a second cathode 40a is placed above the steel core 10 and a second cathode 40b is placed below the steel core 10.

As shown in Figure 1, the first cathodes 30a, 30b are parallel to each other and are transversally positioned with respect to the core path 50. Analogously, the second cathodes 40a, 40b are parallel to each other and are transversally positioned with respect to the core path 50.

Preferably, the distance between the first cathode 30a and the first cathode 30b is comprised between 4 cm and 8 cm.

Preferably, the distance between the first cathodes 30a, 30b and the second cathodes 40a, 40b is comprised between 2 cm and 7 cm.

According to the embodiment shown in Figure 1, the core path 50 is a rectilinear path which consists of a single passage of the steel core 10 inside the vacuum chamber 20, the core entering the vacuum chamber at arrow A and exiting the chamber at arrow B.

According to an alternative and preferred embodiment (not shown), the core deposition path comprises forward and backward lengths - which are arranged in the deposition region comprised among the cathodes - that are covered for a predetermined number of times so as to increase the residence time of the core inside the vacuum chamber until a desired initial thickness of the coating layer is achieved. Preferably, the number of passages of the steel core inside the vacuum chamber is comprised between 20 and 60 at a core speed comprised between 50 and 100 m/min.

According to an alternative and preferred embodiment (not shown), in case a brass coated wire has to be produced, it is preferred that the last passage of the steel core occurs between copper cathodes so that the outermost layer - which is deposited onto the core - is copper since the maximum effectiveness of adhesion between an elastomeric material and the brass coated wire is obtained when the copper content of the brass coating is relatively high at the outer surface of the coating, copper reacting more rapidly than zinc with the elastomeric compound material.

In order to obtain a predetermined thickness of the initial coating layer to be deposited onto the steel core, it is possible to act on the chamber's length, the number of passages of the core inside the chamber, the power to be supplied by the current generators to the cathodes, or combinations thereof.

Furthermore, in order to obtain a predetermined number of deposited layers which constitute the initial coating layer to be deposited onto the wire core, it is possible to act on the number of cathodes, the number of passages of the wire core inside the chamber, or combinations thereof.

As mentioned above, since Figure 1 is a very schematic representation of the deposition chamber, no pre-chambers, no vacuum pump as well as no power supplies of the cathodes have been indicated.

For further description of the invention, some illustrative examples are given below.

### Example 1

A steel wire coated with a brass coating layer was produced by using a magnetron sputtering technique in accordance with the present invention.

In details, a steel wire rod, having a diameter of about 5.5 mm, was subjected to a descaling step and then to an electrolytically pickling step which was carried out in a sulfuric acid bath arranged downstream of the descaling step.

Successively, the core was washed by conveying the core in water, the washing step being provided downstream of the pickling bath, and then a first dry drawing step was carried out to obtain a steel wire having a diameter of about 3.15 mm.

Successively, a first patenting treatment of the core, consisting of a heating step in a furnace at a temperature of about 950°C and of a subsequent cooling step in air to a temperature of about 550°C, was carried out. The exit rate of the core from the furnace was equal to about 70 m/min.

Successively, the core was subjected to a second drawing step and a steel wire having an initial diameter of about 1.14 mm was obtained.

Successively, a second patenting treatment of the core (at the same working conditions of the first patenting treatment mentioned above) followed by a cooling step and a further electrolytically pickling step in a sulfuric acid bath were carried out.

Subsequently, the steel core was fed, in a substantially continuous manner, into a first pre-chamber containing argon at a pressure of about 0.5 mbar.

Subsequently, the core was conveyed, in a substantially continuous manner, to a vacuum deposition chamber wherein argon - at a pressure of about 5x10⁻² mbar - was provided.

The vacuum chamber, having a length of about 5 m, was provided with 10 cathodes of copper and 10 cathodes of zinc. In details, the arrangement of the cathodes within the vacuum chamber was such that pairs of copper cathodes (one cathode upon the steel core and one cathode below the steel core, as indicated by the cathodes 30a, 30b of Figure 1) was separated from and alternate to respective pairs of zinc cathodes (one cathode upon the steel core and one cathode below the steel core, as indicated by the cathodes 40a, 40b of Figure 1).

The distance between a cathode of each pair and the steel core (i.e. the anode) was of about 3 cm.

The distance between a cathode of one pair and the corresponding cathode of the successive pair (i.e. the distance between cathode 30a and cathode 40a) was of about 5 cm.

The cathodes were in the form of rectangular plates having length (measured in the longitudinal direction) of about 45 cm, width (measured in the direction transversal to the advancing direction of the steel core) of about 7 cm and thickness of about 1 cm.

The purity degree of copper and zinc in each respective cathode was of about 99.9%.

The steel core was moved inside the vacuum chamber at a speed of about 70 m/min and the core path - inside the vacuum chamber - was set to 21 passages.

A power of about 5.67 kW was provided to the copper cathode, while a power of about 3.33 kW was provided to the zinc cathode.

At the working conditions described above, 105 copper layers having a thickness of about 9.52 nm and 105 zinc layers having a thickness of about 4.76 nm were obtained.

Therefore, at the end of the deposition step a coating layer having an initial thickness of about 1.5 µm was obtained.

Subsequently, the coated steel core was conveyed, in a substantially continuous manner, in a second pre-chamber containing argon at a pressure of about 0.5 mbar and arranged downstream of the vacuum deposition chamber.

The coated steel core was then subjected to a further drawing step in a bath containing a lubricating oil (which was an emulsion in water of a mixture of fatty acids, esters, amides, amines, surfactants - e.g. Supersol 3453 X^{®} of Rhodia) by means of drawing dies made of tungsten carbide, until a core having a final diameter of about 0.20 mm and a metal coating layer having a final thickness equal of 0.2 µm were obtained.

At the end of the above-mentioned drawing step, a steel wire uniformly and homogeneously coated with brass was obtained. The metal coating layer had and average composition of about 63% by weight of copper and 37% by weight of zinc.

An atomic absorption spectroscopy (AAS) analysis carried out on steel wires coated with a brass coating layer produced in accordance with the embodiment of the process illustrated above has shown that the copper content of the brass coating layer was comprised in the range 63.75-64.25% by weight in the axial direction of the wire.

A scanning electron microscope (SEM) analysis of the same wires has shown that the copper content of the brass coating layer was comprised between 63.5-64.5% by weight in the radial direction of the wire.

Furthermore, an AAS analysis of the same wires has shown that the variation by weight of the amount of brass in the coating layer was equal to about ±0.15 g of brass/kg of steel both in the axial direction and in the radial direction of the wire.

### Example 2

A steel wire coated with a brass coating layer was produced by using a magnetron sputtering technique in accordance with the present invention.

A steel wire rod, having a diameter of about 5.5 mm, was subjected to the descaling, pickling, drawing and patenting steps as described in Example 1.

Successively, the steel core was fed into a first pre-chamber and into a vacuum deposition chamber, the latter being provided with 20 cathodes of copper and 20 cathodes of zinc according to the same arrangement described in Example 1.

The cathodes were in the form of rectangular plates having length (measured in the longitudinal direction) of about 22.5 cm, width (measured in the direction transversal to the advancing direction of the steel core) of about 7 cm and thickness of about 1 cm.

The purity degree of copper and zinc in each respective cathode was of about 99.9%.

The steel core was moved inside the vacuum chamber at a speed of about 70 m/min and the core path - inside the vacuum chamber - was set to 59 passages.

A power of about 6.03 kW was provided to the copper cathode, while a power of about 2.97 kW was provided to the zinc cathode.

At the working conditions and the plant configuration described above, 590 copper layers having a thickness of about 1.69 nm and 590 zinc layers having a thickness of about 0.84 nm were obtained.

Therefore, at the end of the deposition step a coating layer having an initial thickness of about 1.5 µm was obtained.

Subsequently, the coated steel core was conveyed into a second pre-chamber containing argon at a pressure of about 0.5 mbar and arranged downstream of the vacuum deposition chamber.

The coated steel core was then drawn as described in Example 1 until a core having a final diameter of about 0.22 mm and a metal coating layer having a final thickness equal of 0.20 µm were obtained.

At the end of the above-mentioned drawing step, a steel core uniformly and homogeneously coated with brass was obtained. The metal coating layer had and average composition of about 67% by weight of copper and 33% by weight of zinc.

### Example 3

A steel wire coated with a ternary alloy CuZnSn layer was produced by using a magnetron sputtering technique in accordance with the present invention.

A steel wire rod, having a diameter of about 5.5 mm, was subjected to the descaling, pickling, drawing and patenting steps as described in Example 1, the only difference being that the last drawing step was carried out to obtain a steel core diameter of about 1.60 mm (instead of 1.14 mm as described in Example 1).

Successively, the steel core was fed into a first pre-chamber - containing argon at a pressure of about 0.5 mbar - and then into a vacuum deposition chamber wherein argon - at a pressure of about 5x10⁻² mbar - was provided.

The vacuum chamber, having a length of about 5 m, was provided with 20 cathodes of copper, 18 cathodes of zinc and 2 cathodes of tin. The tin cathodes were arranged in the center of the deposition chamber, i.e. in the middle of the alternate sequence of copper and zinc cathodes.

The distance between a cathode of each pair and the steel core (i.e. the anode) was of about 3 cm.

The distance between a cathode of one pair and the corresponding cathode of the successive pair (i.e. the distance between cathode 30a and cathode 40a) was of about 5 cm.

The cathodes were in the form of rectangular plates having length (measured in the longitudinal direction) of about 22.5 cm, width (measured in the direction transversal to the advancing direction of the steel core) of about 7 cm and thickness of about 1 cm.

The purity degree of copper, zinc, and tin in each respective cathode was of about 99.9%.

The steel core was moved inside the vacuum chamber at a speed of about 50 m/min and the core path - inside the vacuum chamber - was set to 59 passages.

A power of about 6.03 kW was provided to the copper cathode, a power of about 2.7 kW was provided to the zinc cathode and a power of about 0.27 kW was provided to the tin cathode respectively.

At the working conditions and the plant configuration described above, 590 copper layers having a thickness of about 1.69 nm, 531 zinc layers having a thickness of about 0.84 nm and 59 layers of tin having a thickness of 1.1 nm were obtained.

Therefore, at the end of the deposition step a coating layer having an initial thickness of about 1.5 µm was obtained.

Subsequently, the coated steel core was conveyed into a second pre-chamber containing argon at a pressure of about 0.5 mbar and arranged downstream of the vacuum deposition chamber.

The coated steel core was then drawn in a substantially continuous manner as described in Example 1 until a core having a final diameter of about 0.22 mm and a metal coating layer having a final thickness equal of 0.20 µm were obtained.

At the end of the above-mentioned drawing step, a steel core uniformly and homogeneously coated with a ternary alloy (copper 67%, zinc 30% and tin 3% - average composition of the metal coating) was obtained.

### Example 4 (comparative)

A steel wire coated with a brass coating layer was produced by using a sequential electrodeposition system as disclosed in document EP-1 004 689.

A steel wire rod, having a diameter of about 5.5 mm, was subjected to the descaling, pickling, drawing and patenting steps as described in Example 1.

Successively, copper and zinc plating by electrodeposition was carried out to obtain an alternate sequence of 4 copper layers and 3 zinc layers to be deposited onto the steel core. The total thickness of the metal coating layer was of about 1.5 µm.

Each copper layer had a thickness of about 0.25 µm and each zinc layer had a thickness of about 0.17 µm.

The coated steel core was finally drawn as described in Example 1 until a core having a final diameter of about 0.22 mm and a metal coating layer having a final thickness of about 0.20 µm were obtained.

The obtained coating layer was analyzed by means of the X-ray diffraction technique. It was noted that the steel core was not uniformly and homogeneously coated since a remarkable percentage (about 20% by weight) of non-diffused copper and a remarkable percentage (about 10% by weight) of a brass were present in the brass coating layer.

## Claims

1. A process for producing a metal wire comprising a steel core and a metal coating layer in a radially outer position with respect to said steel core, the metal coating layer comprising an alloy made of at least two metal components, said process comprising the steps of:
- coating the steel core by depositing onto said steel core separate layers, each layer being made of at least one metal component of said at least two metal components, each layer having a thickness not higher than 50 nm, and
- drawing the coated core to form said alloy.

2. Process according to claim 1, wherein said thickness is comprised between 0.5 nm and 20 nm.

3. Process according to claim 2, wherein said thickness is comprised between 1.0 nm and 10 nm.

4. Process according to claim 1, wherein the step of coating is carried out by alternately depositing onto said steel core said separate layers.

5. Process according to claim 1, wherein at least one of the separate layers is made of an alloy made of said at least two metal components.

6. Process according to claim 1, wherein the step of coating is carried out by means of a plasma deposition technique.

7. Process according to claim 6, wherein said plasma deposition technique is selected from: sputtering, evaporation by voltaic arc, plasma spray and plasma enhanced chemical vapor deposition (PECVD).

8. Process according to claim 6, wherein the step of coating is carried out in at least one vacuum deposition chamber at a first predetermined pressure.

9. Process according to claim 8, wherein said first predetermined pressure is comprised in the range from about 10⁻³ to about 10⁻¹ mbar.

10. Process according to claim 1, wherein the steel core is continuously coated and drawn while being conveyed at a speed comprised in the range from about 10 to about 80 m/min.

11. Process according to claim 1, wherein the steel core has a predetermined initial diameter, the coating layer has a predetermined initial thickness, and the step of drawing the coated core is carried out until the steel core has a final diameter smaller than said predetermined initial diameter and the metal coating layer has a final thickness smaller than said predetermined initial thickness.

12. Process according to claim 11, wherein the predetermined initial thickness of the coating layer is comprised between about 0.5 and about 2.0 mm.

13. Process according to claim 11, wherein the final thickness of the coating layer is comprised between about 80 and about 350 nm.

14. Process according to claim 11, wherein the predetermined initial diameter of the steel core is comprised in the range from about 0.85 and about 3.00 mm.

15. Process according to claim 11, wherein the predetermined final diameter of the steel core is comprised in the range from 0.10 to 0.50 mm.

16. Process according to claim 8, further comprising a step of conveying the steel core in at least one pre-chamber at a second predetermined pressure higher than said first predetermined pressure, said pre-chamber being arranged upstream of said at least one vacuum deposition chamber.

17. Process according to claim 16, wherein said second predetermined pressure is comprised between about 0.2 mbar to about 10 mbar.

18. Process according to claim 8, wherein the steel core is made to pass through a sequence of at least two cathodes arranged inside the vacuum deposition chamber, each cathode being made of a metal component of said at least two metal components to be deposited onto the steel core.

19. Process according to claim 8, wherein the steel core passes through the vacuum chamber according to multiple passages.

20. Process according to claim 1, wherein said alloy forming the coating layer is different from the steel forming the core.

21. Process according to claim 1, wherein the metals of the coating layer are selected from: copper, zinc, manganese, cobalt, tin, molybdenum, iron, nickel, aluminum and alloys thereof.

22. Process according to claim 21, wherein the coating layer is made of brass.

23. Process according to claim 22, wherein the brass has a copper content of from about 60 to about 72% by weight.

24. Process according to claim 1, further comprising the step of submitting the steel core to at least one surface treatment.

25. Process according to claim 24, wherein said at least one surface treatment comprises the step of pickling the core into a pickling bath.

26. Process according to claim 25, further comprising the step of washing the pickled core into water.

27. Process according to claim 26, further comprising the step of drying the washed core.

28. Process according to claim 1, further comprising the step of thermally treating the steel core.

29. Process according to claims 24 and 28, wherein the step of thermally treating the steel core is carried out after the step of submitting the steel core to the least one surface treatment.

30. Process according to claim 28, further comprising the step of dry drawing the steel core before carrying out the thermal treatment step.

## Patentansprüche

1. Verfahren zur Herstellung eines Metalldrahts, umfassend einen Stahlkern sowie eine metallische Belagschicht in einer radial äußeren Position in Bezug auf den Stahlkern, wobei die metallische Belagschicht eine Legierung umfasst, die aus zumindest zwei Metallkomponenten hergestellt ist, wobei das Verfahren die folgenden Schritte umfasst:
- Beschichten des Stahlkerns mittels Abscheiden verschiedener Schichten auf dem Stahlkern, wobei jede Schicht aus zumindest einer Metallkomponente dieser zumindest zwei Metallkomponenten gefertigt ist und jede Schicht eine Dicke von nicht mehr als 50 nm aufweist, und
- Zugumformen des beschichteten Kerns zur Ausbildung dieser Legierung.

2. Verfahren gemäß Anspruch 1, wobei die Dicke zwischen 0,5 nm und 20 nm beträgt.

3. Verfahren gemäß Anspruch 2, wobei die Dicke zwischen 1,0 nm und 10 nm beträgt.

4. Verfahren gemäß Anspruch 1, wobei der Schritt der Beschichtung durch abwechselndes Abscheiden verschiedener Schichten auf dem Stahlkern ausgeführt wird.

5. Verfahren gemäß Anspruch 1, wobei zumindest eine der separaten Schichten aus einer Legierung gefertigt ist, die aus den zumindest zwei Metallkomponenten gefertigt ist.

6. Verfahren gemäß Anspruch 1, wobei der Schritt der Beschichtung mittels einer Plasmaabscheidungstechnik ausgeführt wird.

7. Verfahren gemäß Anspruch 6, wobei die Plasmaabscheidungstechnik ausgewählt wird aus: Sputtern, Verdampfung durch einen Spannungsbogen, Plasmasprühen und plasmagestützte Gasphasenabscheidung (PECVD).

8. Verfahren gemäß Anspruch 6, wobei der Schritt der Beschichtung in zumindest einer vakuumabscheidekammer bei einem ersten vorab festgelegten Druck ausgeführt wird.

9. Verfahren gemäß Anspruch 8, wobei der erste vorab festgelegte Druck im Bereich von etwa 10⁻³ bis etwa 10⁻¹ mbar liegt.

10. Verfahren gemäß Anspruch 1, wobei der Stahlkern kontinuierlich beschichtet und zugumgeformt wird, während er bei einer Geschwindigkeit im Bereich von etwa 10 bis etwa 80 m/min befördert wird.

11. Verfahren gemäß Anspruch 1, wobei der Stahlkern einen vorab festgelegten Anfangsdurchmesser aufweist, die Belagschicht eine vorab festgelegte Anfangsdicke aufweist und der Schritt zur Zugumformung des beschichteten Kerns ausgeführt wird, bis der Stahlkern einen abschließenden Durchmesser aufweist, der kleiner als der vorab festgelegte Anfangsdurchmesser ist, und die Metallbelagschicht eine abschließende Dicke aufweist, die kleiner als die vorab festgelegte Anfangsdicke ist.

12. Verfahren gemäß Anspruch 11, wobei die vorab festgelegte Anfangsdicke der Belagschicht zwischen etwa 0,5 und etwa 2,0 mm beträgt.

13. Verfahren gemäß Anspruch 11, wobei die abschließende Dicke der Belagschicht zwischen etwa 80 und etwa 350 nm beträgt.

14. Verfahren gemäß Anspruch 11, wobei der vorab festgelegte Anfangsdurchmesser des Stahlkerns im Bereich von etwa 0,85 bis etwa 3,00 mm beträgt.

15. Verfahren gemäß Anspruch 11, wobei der vorab festgelegte Enddurchmesser des Stahlkerns im Bereich von 0,10 bis 0,50 mm liegt.

16. Verfahren gemäß Anspruch 8, des Weiteren umfassend den Schritt der Beförderung des Stahlkerns in zumindest eine Vorkammer bei einem zweiten vorab festgelegten Druck, der höher als der erste vorab festgelegte Druck ist, wobei die Vorkammer stromaufwärts der zumindest einen Vakuumabscheidekammer angeordnet ist.

17. Verfahren gemäß Anspruch 16, wobei der zweite vorab festgelegte Druck zwischen etwa 0,2 mbar und etwa 10 mbar beträgt.

18. Verfahren gemäß Anspruch 8, wobei der Stahlkern so gefertigt ist, dass er durch eine Reihe von zumindest zwei Kathoden hindurch tritt, die innerhalb der Vakuumabscheidekammer angeordnet sind, wobei jede Kathode aus einer Metallkomponente der zumindest zwei Metallkomponenten gefertigt ist, die auf dem Stahlkern abgeschieden werden sollen.

19. Verfahren gemäß Anspruch 8, wobei der Stahlkern durch die Vakuumkammer in einer Vielzahl von Durchgängen hindurch tritt.

20. Verfahren gemäß Anspruch 1, wobei die die Belagschicht ausbildende Legierung sich von dem den Kern ausbildenden Stahl unterscheidet.

21. Verfahren gemäß Anspruch 1, wobei die Metalle der Belagschicht ausgewählt werden aus: Kupfer, Zink, Mangan, Kobalt, Zinn, Molybdän, Nickel, Aluminium sowie deren Legierungen.

22. Verfahren gemäß Anspruch 21, wobei die Belagschicht aus Messing besteht.

23. Verfahren gemäß Anspruch 22, wobei das Messing einen Kupfergehalt von etwa 60 bis 72 Gew-% aufweist.

24. Verfahren gemäß Anspruch 1, des Weiteren umfassend den Schritt der Unterziehung des Stahlkerns zumindest einer Oberflächenbehandlung.

25. Verfahren gemäß Anspruch 24, wobei die zumindest eine Oberflächenbehandlung den Schritt der Beizung des Kerns in einem Beizbad umfasst.

26. Verfahren gemäß Anspruch 25, des Weiteren umfassend den Schritt des Reinigens des gebeizten Kerns in Wasser.

27. Verfahren gemäß Anspruch 26, des Weiteren umfassend den Schritt der Trocknung des gereinigten Kerns.

28. Verfahren gemäß Anspruch 1, des Weiteren umfassend den Schritt der thermischen Behandlung des Stahlkerns.

29. Verfahren gemäß den Ansprüchen 24 und 28, wobei der Schritt der thermischen Behandlung des Stahls nach dem Schritt des Unterziehens des Stahlkerns zumindest einer Oberflächenbehandlung ausgeführt wird.

30. Verfahren gemäß Anspruch 28, des Weiteren umfassend den Schritt des Trocken-Zugumformens des Stahlkerns vor dem Ausführen des thermischen Behandlungsschritts.

## Revendications

1. Procédé de production d'un fil métallique comprenant une âme en acier et une couche de revêtement métallique dans une position radialement extérieure par rapport à ladite âme en acier, la couche de revêtement métallique comprenant un alliage constitué d'au moins deux composants métalliques, ledit procédé comprenant les étapes consistant à :
- revêtir l'âme en acier en déposant sur ladite âme en acier des couches séparées, chaque couche étant faite d'au moins un composant métallique parmi lesdits au moins deux composants métalliques, chaque couche ayant une épaisseur qui ne dépasse pas 50 nm, et
- tréfiler l'âme revêtue pour former ledit alliage.

2. Procédé selon la revendication 1, dans lequel ladite épaisseur est comprise entre 0,5 nm et 20 nm.

3. Procédé selon la revendication 2, dans lequel ladite épaisseur est comprise entre 1,0 nm et 10 nm.

4. Procédé selon la revendication 1, dans lequel l'étape de revêtement est exécutée en déposant alternativement lesdites couches séparées sur ladite âme en acier.

5. Procédé selon la revendication 1, dans lequel au moins l'une des couches séparées est faite d'un alliage constitué desdits au moins deux composants métalliques.

6. Procédé selon la revendication 1, dans lequel l'étape de revêtement est exécutée au moyen d'une technique de dépôt par plasma.

7. Procédé selon la revendication 6, dans lequel ladite technique de dépôt par plasma est choisie parmi la pulvérisation, l'évaporation par arc voltaïque, la projection au plasma et le dépôt chimique en phase vapeur assisté par plasma (PECVD).

8. Procédé selon la revendication 6, dans lequel l'étape de revêtement est exécutée dans au moins une chambre de dépôt sous vide à une première pression prédéterminée.

9. Procédé selon la revendication 8, dans lequel ladite première pression prédéterminée est comprise dans l'intervalle d'environ 10-³ à environ 10⁻¹ mbar.

10. Procédé selon la revendication 1, dans lequel l'âme en acier est revêtue et tréfilée en continu tout en étant déplacée à une vitesse comprise dans l'intervalle d'environ 10 à environ 80 m/min.

11. Procédé selon la revendication 1, dans lequel l'âme en acier a un diamètre initial prédéterminé, la couche de revêtement a une épaisseur initiale prédéterminée, et l'étape de tréfilage de l'âme revêtue est exécutée jusqu'à ce que l'âme en acier ait un diamètre final plus petit que ledit diamètre initial prédéterminé et jusqu'à ce que la couche de revêtement métallique ait une épaisseur finale inférieure à ladite épaisseur initiale prédéterminée.

12. Procédé selon la revendication 11, dans lequel l'épaisseur initiale prédéterminée de la couche de revêtement est comprise entre environ 0,5 et environ 2,0 mm.

13. Procédé selon la revendication 11, dans lequel l'épaisseur finale de la couche de revêtement est comprise entre environ 80 et environ 350 nm.

14. Procédé selon la revendication 11, dans lequel le diamètre initial prédéterminé de l'âme en acier est compris dans l'intervalle d'environ 0,85 à environ 3,00 mm.

15. Procédé selon la revendication 11, dans lequel le diamètre final prédéterminé de l'âme en acier est compris dans l'intervalle de 0,10 à 0,50 mm.

16. Procédé selon la revendication 8, comprenant en outre une étape consistant à déplacer l'âme en acier dans au moins une chambre préliminaire à une deuxième pression prédéterminée, supérieure à ladite première pression prédéterminée, ladite chambre préliminaire étant placée en amont de ladite au moins une chambre de dépôt sous vide.

17. Procédé selon la revendication 16, dans lequel ladite deuxième pression prédéterminée est comprise entre environ 0,2 mbar et environ 10 mbar.

18. Procédé selon la revendication 8, dans lequel on fait passer l'âme en acier successivement par au moins deux cathodes placées à l'intérieur de la chambre de dépôt sous vide, chaque cathode étant faite d'un composant métallique parmi lesdits au moins deux composants métalliques devant être déposés sur l'âme en acier.

19. Procédé selon la revendication 8, dans lequel l'âme en acier passe dans la chambre sous vide suivant plusieurs passages.

20. Procédé selon la revendication 1, dans lequel ledit alliage formant la couche de revêtement est différent de l'acier formant l'âme.

21. Procédé selon la revendication 1, dans lequel les métaux de la couche de revêtement sont choisis parmi le cuivre, le zinc, le manganèse, le cobalt, l'étain, le molybdène, le fer, le nickel, l'aluminium et leurs alliages,

22. Procédé selon la revendication 21, dans lequel la couche de revêtement est en laiton.

23. Procédé selon la revendication 22, dans lequel le laiton a une teneur en cuivre d'environ 60 à environ 72 % en poids.

24. Procédé selon la revendication 1, comprenant en outre l'étape consistant à soumettre l'âme en acier à au moins un traitement de surface.

25. Procédé selon la revendication 24, dans lequel ledit au moins un traitement de surface comprend l'étape consistant à décaper l'âme dans un bain de décapage.

26. Procédé selon la revendication 25, comprenant en outre l'étape consistant à laver l'âme décapée dans de l'eau.

27. Procédé selon la revendication 26, comprenant en outre l'étape consistant à sécher l'âme lavée.

28. Procédé selon la revendication 1, comprenant en outre l'étape consistant à faire subir un traitement thermique à l'âme en acier.

29. Procédé selon les revendications 24 et 28, dans lequel l'étape de traitement,thermique de l'âme en acier est exécutée après l'étape consistant à soumettre l'âme en acier à au moins un traitement de surface.

30. Procédé selon la revendication 28, comprenant en outre l'étape consistant à tréfiler à sec l'âme en acier avant d'exécuter l'étape de traitement thermique.
